# FASCICULE DE BREVET EUROPEEN

(11) **EP 0 838 826 B1**
(45) Date de publication et mention de la délivrance du brevet: **04.08.1999**
(21) Numéro de dépôt: 97460043.9
(22) Date de dépôt: 21.10.1997
(51) Int. Cl.: G11C 11/56

(54) **Mémoire non volatile multiniveau modifiable électriquement comportant des moyens de rafraîchissement internes**
Elektrisch modifizierbarer nichtflüchtiger Mehrpegelspeicher mit internen Auffrischungsmitteln
Electrically alterable non-volatile multilevel memory having internal refreshing means

(30) Priorité: 25.10.1996 FR 9613290
(43) Date de publication de la demande: 29.04.1998
(73) Titulaire: STMicroelectronics S.A., 94250 Gentilly (FR)
(72) Inventeur: Yero, Emilio Miguel, 56100 Lorient (FR)
(74) Mandataire: Schmit, Christian Norbert Marie

(56) Documents cités:
- EP-A- 0 685 852
- FR-A- 2 687 811

## Description

L'invention concerne une mémoire non volatile multiniveau modifiable électriquement comportant des moyens de rafraîchissement internes. L'invention trouve tout particulièrement son application dans le domaine des mémoires de capacité importante, de l'ordre de plusieurs dizaines de mégabits.

Il existe plusieurs techniques pour augmenter la densité des mémoires. L'une d'entre elles consiste à emmagasiner plusieurs bits d'information dans une même cellule mémoire. On parle alors de mémoires multiniveau. Les mémoires classiques mémorisent un bit d'information par cellule mémoire, c'est-à-dire deux états de programmation. Ces états correspondent à la présence ou à l'absence de charges électriques dans la grille flottante des transistors constituant la cellule mémoire élémentaire. Les mémoires multiniveau, quant à elles, permettent d'emmagasiner un nombre plus important d'états de programmation par cellule mémoire.

Le brevet FR 0 340 107 décrit une mémoire multiniveau non volatile modifiable électriquement. Chaque cellule de la mémoire est capable de mémoriser n états de programmation possibles, avec n au moins égal à trois. Ces différents états de programmation sont obtenus en faisant varier le seuil de conduction du transistor à grille flottante constituant la cellule mémoire. Pour obtenir cette variation de seuil de conduction, on programme plus ou moins fortement la cellule en faisant varier l'intensité de la programmation, c'est-à-dire soit la tension appliquée à la cellule, soit la durée d'application de la tension. Pour la lecture des informations contenues dans la mémoire, on compare un courant ou une tension fonction de l'état de programmation de la cellule avec n-1 valeurs de référence pour en déduire l'état de programmation de la cellule mémoire parmi n états possibles.

Cependant, le nombre important d'états de programmation dans une mémoire multiniveau et la taille restreinte des plages de tension ou de courant de ces états peuvent alors poser des problèmes.

En effet, il arrive que des déplacements incontrôlés de charges électriques aient lieu lors d'opération de programmation ou d'effacement de la mémoire. Par exemple, lors de la programmation d'une cellule mémoire d'une mémoire multiniveau de type FLASH EPROM, on applique une haute tension Vpp sur la ligne de mot reliée à la grille de commande de la cellule et une tension Vp plus faible sur la ligne de bit reliée au drain de la cellule. Les sources de l'ensemble des cellules appartenant au même secteur sont reliées à la masse pendant la programmation. Les cellules reliées à la même ligne de mot sont alors soumises à un champ électrique qui peut être responsable d'un déplacement de charges électriques et de la perte d'un état de programmation si la taille de la plage de tension ou de courant de cet état est relativement réduite.

Une perte de charges électriques peut également se produire en mode lecture à un niveau moindre qu'en mode écriture. Ceci ne pose pas de gros problèmes pour une mémoire classique car la dégradation du seuil de conduction des cellules est faible, cependant cela peut être plus inquiétant pour les mémoires multiniveau.

Pour remédier à ces problèmes de perte de niveau, il est indispensable de rafraîchir régulièrement les cellules mémoires de la mémoire multiniveau.

De manière classique, l'opération de rafraîchissement de la mémoire pourrait être effectuée sous le contrôle d'une unité de commande externe à la mémoire. Tout accès à la mémoire serait alors rendu impossible pendant l'opération de rafraîchissement.

Une autre solution possible consisterait en une mémoire comportant une matrice principale de cellules mémoires non volatiles et une matrice secondaire de cellules mémoires statiques prévue pour mémoriser temporairement des données de la matrice principale. La taille de la matrice secondaire serait par exemple égale à celle d'un secteur de la matrice principale. L'opération de rafraîchissement qui serait effectué par des moyens internes à la mémoire comporterait les deux étapes suivantes: une étape de duplication des données d'un secteur de la matrice principale dans la matrice secondaire, et une étape de rafraîchissement des données du secteur dupliqué de la matrice principale. Pendant l'étape de rafraîchissement, les données du secteur en cours de rafraîchissement seraient alors accessibles en lecture à partir de la matrice secondaire. Dans cet exemple de réalisation, la matrice secondaire est constitué de cellules mémoire statiques afin de minimiser le temps de duplication des données.

Cependant, cette solution présente trois inconvénients majeurs:
- la mémoire comporte sur un même circuit intégré des cellules mémoires de deux types différents donc de deux technologies différentes; cela pose des problèmes de coût et de fabrication;
- les données à rafraîchir subissent un traitement relativement long en deux étapes: une étape de duplication et une étape de rafraîchissement proprement dite; et
- pendant le rafraîchissement de la mémoire, les données sont dupliquées dans une mémoire tampon qui est volatile; ceci rend la mémoire vulnérable aux coupures d'alimentation.

Aussi, le but de l'invention est de proposer une mémoire multiniveau avec rafraîchissement interne comportant uniquement des cellules mémoire non volatiles et dans laquelle on limite le nombre des étapes effectuées sur les données à rafraîchir.

L'invention a pour objet une mémoire non volatile modifiable électriquement comportant une matrice de cellules mémoire chacune susceptible de mémoriser au moins deux bits d'information, laquelle matrice est divisée en n secteurs de stockage de données, des moyens d'adressage et de programmation de ladite matrice, l'ensemble étant commandé par un circuit de commande comprenant des moyens de rafraîchissement, ladite mémoire étant caractérisée en ce que, dans la matrice, n-1 secteurs seulement sont affectés simultanément au stockage des données, le secteur restant ou secteur de rafraîchissement étant alors disponible à des fins de rafraîchissement pour la duplication de l'un desdits n-1 secteurs affectés simultanément au stockage des données, et en ce que, après chaque duplication, le secteur dupliqué est remplacé par ledit secteur de rafraîchissement et devient lui-même le nouveau secteur de rafraîchissement, de telle sorte que l'ensemble des n secteurs participent tour à tour au rafraîchissement.

Ainsi, les données du secteur à rafraîchir subissent uniquement une étape de duplication.

Avantageusement, pour rafraîchir un secteur parmi les n-1 secteurs affectés simultanément au stockage des données, on effectue les étapes suivantes :
(a) duplication des données du secteur à rafraîchir dans le secteur de rafraîchissement;
(b) modification des adresses des données du secteur dupliqué pour qu'elles pointent sur les données du secteur de rafraîchissement;
(c) effacement du secteur dupliqué qui devient le nouveau secteur de rafraîchissement;

Pour réaliser l'étape (b), les moyens d'adressage de ladite matrice comportent des moyens programmables pour réorganiser après duplication le pointage desdites adresses qui correspondaient au secteur dupliqué vers le nouveau secteur qui a remplacé ce dernier.

De préférence, les moyens programmables comportent n blocs de comparaison, chaque bloc de comparaison étant associé à un secteur de la matrice, pour réorganiser les adresses des secteurs de la mémoire.

Dans un mode de réalisation préféré, on prévoit qu'à chaque opération de duplication, le secteur de rafraîchissement et le secteur à dupliquer soient physiquement contigus de façon à obtenir un rafraîchissement tournant des secteurs de la mémoire.

D'autres caractéristiques et avantages de l'invention apparaîtront à la lecture de la description détaillée qui suit et qui est faite en référence aux dessins annexés dans lesquels:
- la figure 1 représente un exemple de réalisation d'une mémoire selon l'invention;
- la figure 2 représente un schéma détaillé des moyens d'adressage selon l'invention; et
- la figure 3 représente un schéma d'un bloc de comparaison des moyens d'adressage selon l'invention.

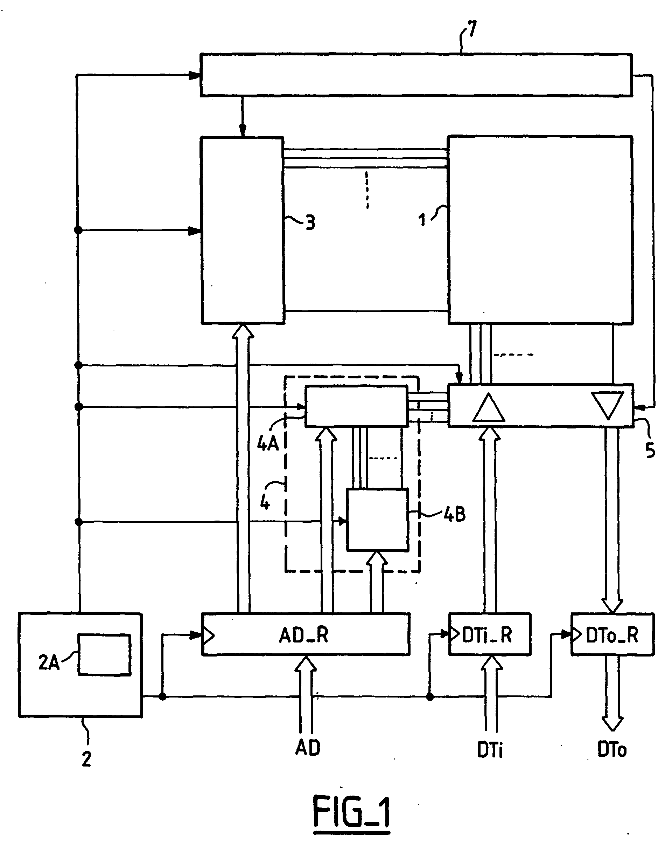

La figure 1 représente un exemple de structure d'une mémoire FLASH EPROM adaptée pour mettre en oeuvre l'invention.

La mémoire comprend une matrice 1 de cellules mémoires reliées à un décodeur de lignes 3 et un décodeur de colonnes 4 associés à des circuits de lecture et d'écriture 5. L'écriture de la matrice 1 est effectuée au moyen d'un circuit de programmation 7 essentiellement constitué d'un oscillateur, d'un élévateur de tension et d'un générateur de rampe.

Les décodeurs 3 et 4 sont reliés à un registre d'adresse AD-R. Les circuits de lecture et d'écriture 5 sont reliés respectivement à un registre de données de sortie DTo-R et à un registre de données d'entrée DTi-R. Les registres AD-R, DTo-R et DTi-R communiquent avec l'extérieur de la mémoire par l'intermédiaire d'une interface (non représentée). Les registres AD-R et DTi-R reçoivent respectivement des adresses AD et des données DTi alors que le registre DTo-R délivre des données DTo.

L'ensemble est contrôlé par un circuit de commande 2. Le circuit 2 sera par exemple réalisé au moyen d'un réseau logique programmable (PLA) conçu pour fournir les signaux de commande aux différents circuits de la mémoire.

Le circuit de commande 2 comporte par ailleurs des moyens de rafraîchissement 2A prévus pour exécuter les opérations de rafraîchissement de la mémoire.

Pour la mise en oeuvre de l'invention, la matrice 1 est munie d'un secteur supplémentaire de stockage des données et le décodeur de colonnes 4 comprend des moyens programmables 4B de sélection des secteurs de la matrice 1. Le décodeur de colonnes 4 et les moyens programmables 4B seront détaillés dans la suite de la description.

Selon l'invention, si on considère une mémoire dont la matrice 1 comporte n secteurs de stockage de données, n-1 secteurs sont affectés simultanément au stockage des données et le secteur restant appelé secteur de rafraîchissement est prévu pour recevoir les données dupliquées de l'un desdits n-1 secteurs. Par ailleurs, l'opération de rafraîchissement qui est essentiellement une opération de duplication, est effectuée secteur par secteur et l'ensemble des n secteurs de la matrice deviennent tour à tour le secteur de rafraîchissement.

Le rafraîchissement de la mémoire se déroule de la manière suivante: on suppose tout d'abord que le secteur n est le secteur de rafraîchissement; ce secteur est de préférence vide. On choisit par ailleurs de commencer le rafraîchissement de la mémoire par le secteur n-1 qui correspond au secteur physiquement contigu au secteur de rafraîchissement. On va ainsi effectuer un rafraîchissement tournant des secteurs de la mémoire.

Dans un premier temps, les données du secteur n-1 sont dupliquées dans le secteur n. Les données qui étaient mémorisées dans le secteur n-1 sont alors disponibles dans le secteur n. Le décodeur de colonnes 4 est ensuite, dans un second temps, reprogrammé pour que les adresses de ces données pointent désormais sur les données dupliquées du secteur n. Puis, le secteur n-1 est effacé et devient le nouveau secteur de rafraîchissement. L'opération de rafraîchissement se poursuit ensuite en dupliquant les données du secteur n-2 dans le nouveau secteur de rafraîchissement, c'est-à-dire le secteur n-1, et ainsi de suite.

Le fait que le secteur sollicité pour le rafraîchissement ne soit pas toujours le même, permet de garantir une grande fiabilité du système.

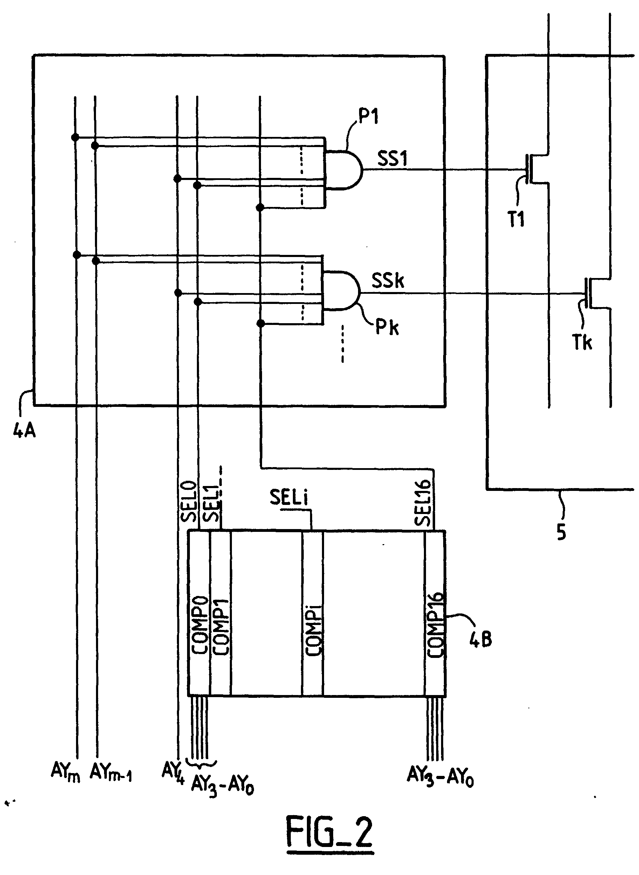

Selon l'invention, le décodeur de colonnes 4 de la matrice 1 comporte des moyens programmables 4B pour réorganiser le pointage des adresses des données du secteur dupliqué vers le secteur qui l'a remplacé. Le décodeur de colonnes est détaillé à la figure 2.

Dans cet exemple de réalisation du décodeur 4, la matrice de la mémoire considérée comporte dix-sept secteurs dont seize sont affectés simultanément au stockage de données. Selon l'invention, cette mémoire ne comporte que seize secteurs visibles du point de vue de l'utilisateur. Aussi, il n'y aura que quatre bits d'adresse pour sélectionner un secteur de la matrice.

Le décodeur de colonnes 4 est composé d'un réseau de portes logiques 4A et de moyens programmables 4B. Il permet de sélectionner des lignes de bits de la matrice 1 en fonction de l'adresse de colonnes AYm-AY0. Dans l'exemple de la figure 2, les bits d'adresse AY3-AY0 sont représentatifs d'un secteur de la matrice 1.

Les moyens programmables 4B comportent n blocs de comparaison COMPi, chacun étant associé à un secteur de la matrice 1. Chaque bloc de comparaison reçoit les bits d'adresse de secteur AY0-AY3 et délivre un signal de sélection de secteur SELi. En pratique, chaque bloc compare l'adresse de secteur AY0-AY3 à une adresse de secteur mémorisée dans le bloc. Si les deux adresses sont identiques, le bloc de comparaison concerné COMPi délivre un signal de sélection SELi présentant un "1" logique.

Les signaux de sélection SELi ainsi que les bits d'adresse AY4-AYm sont ensuite traités par le réseau de portes logiques 4A pour sélectionner une ou plusieurs lignes de bit de la matrice 1. Dans l'exemple de la figure 2, ce réseau comprend des portes logiques Pk de type ET à m+14 entrées délivrant chacune un signal de sélection SSk. Les signaux de sélection SSk permettent de sélectionner des lignes de bit de la matrice 1 au moyen de transistors de passage Tk prévus dans le circuit de lecture et d'écriture 5.

Des inverseurs non représentés sur la figure 2, sont également prévus sur un certain nombre d'entrées des portes logiques Pk; ces inverseurs sont disposés de manière à activer un signal de sélection différent pour chaque combinaison possible des signaux d'entrée AY4-AYm et SEL0-SEL14.

Comme on dispose de dix-sept secteurs dans la matrice et que l'adresse de secteur AY0-AY3 ne comprend que quatre bits, on prévoit un bit supplémentaire appelé bit d'activation pour distinguer le secteur de rafraîchissement des seize autres secteurs de la matrice. A chaque adresse de secteur préenregistrée dans le bloc de comparaison, on fait correspondre un bit d'activation indiquant si le secteur est accessible ou non par l'utilisateur. Le secteur de rafraîchissement n'étant jamais accessible, le bit d'activation s'y rapportant est donc à "0". Il y aura toujours seize secteurs dont le bit d'activation associé est à "1" et un secteur dont le bit d'activation est à "0".

Le fonctionnement des moyens programmables 4B est illustré par le tableau qui suit: au départ, le secteur 16 correspond au secteur de rafraîchissement, et le bit d'activation qui lui est associé dans le bloc de comparaison COMP16 est à "0". Les seize premiers secteurs ont chacun une adresse propre et leur bit d'activation associé est à "1". Après chaque opération de duplication, on reprogramme l'adresse et le bit d'activation des blocs de comparaison correspondant au secteur dupliqué et au secteur de rafraîchissement.

| Sect. | rafraîchiss^{t} secteur 15 | | rafraîchiss^{t} secteur 14 | | rafraîchiss^{t} secteur 13 | |
|---|---|---|---|---|---|---|
| | Adr | Bit | Adr | Bit | Adr | Bit |
| 0 | 0000 | 1 | 0000 | 1 | 0000 | 1 |
| 1 | 0001 | 1 | 0001 | 1 | 0001 | 1 |
| 2 | 0010 | 1 | 0010 | 1 | 0010 | 1 |
| 3 | 0011 | 1 | 0011 | 1 | 0011 | 1 |
| 4 | 0100 | 1 | 0100 | 1 | 0100 | 1 |
| 5 | 0101 | 1 | 0101 | 1 | 0101 | 1 |
| 6 | 0110 | 1 | 0110 | 1 | 0110 | 1 |
| 7 | 0111 | 1 | 0111 | 1 | 0111 | 1 |
| 8 | 1000 | 1 | 1000 | 1 | 1000 | 1 |
| 9 | 1001 | 1 | 1001 | 1 | 1001 | 1 |
| 10 | 1010 | 1 | 1010 | 1 | 1010 | 1 |
| 11 | 1011 | 1 | 1011 | 1 | 1011 | 1 |
| 12 | 1100 | 1 | 1100 | 1 | 1100 | 1 |
| 13 | 1101 | 1 | 1101 | 1 | 1101 | 1 |
| 14 | 1110 | 1 | 1110 | 1 | 1101 | 0 |
| 15 | 1111 | 1 | 1110 | 0 | 1110 | 1 |
| 16 | 1111 | 0 | 1111 | 1 | 1111 | 1 |
| Rafraîchiss^{t} = rafraîchissement | | | | | | |
| Sect = Secteur | | | | | | |
| Adr = Adresse | | | | | | |
| Bit = Bit d'activation | | | | | | |

Ce tableau résume les diverses opérations effectuées sur les adresses et les bits d'activation des différents blocs de comparaison pour le rafraîchissement des secteurs 15, 14 et 13.

En début de rafraîchissement du secteur 15, les blocs de comparaison COMP15 et COMP16 contiennent la même adresse : 1111. Cependant, le secteur 16 qui correspond au secteur de rafraîchissement ne doit pas être pas accessible pour l'utilisateur pendant le rafraîchissement du secteur 15; le bit d'activation du bloc COMP16 est donc à "0". Pendant l'opération de rafraîchissement, les données du secteur 15 sont dupliquées dans le secteur 16.

A la fin de l'opération de duplication, le bit d'activation du bloc de comparaison COMP15 est mis à "0" et le secteur 15 devient le nouveau secteur de rafraîchissement. On recopie également l'adresse du secteur 14 dans le bloc associé au secteur 15 en vue du rafraîchissement du secteur 14. Par ailleurs, le bit d'activation du bloc COMP16 est mis à "1" et les adresses des données qui étaient contenus dans le secteur 15 pointent désormais sur les données du secteur 16.

Pour le rafraîchissement du secteur 14, les données du secteur 14 sont dupliquées dans le secteur 15. A la fin de cette opération de duplication, le bit d'activation du bloc COMP15 est mis à "1" tandis que le bit d'activation du bloc COMP14 est mis à "0". L'adresse mémorisée dans le bloc de comparaison COMP14 est par ailleurs modifiée en vue du rafraîchissement du secteur 13.

Dans ce mode de réalisation où le mode rafraîchissement est tournant, la position du bit d'activation à zéro permet de déterminer le dernier secteur de la matrice qui a été rafraîchi. Ainsi, après chaque mise en fonctionnement de la mémoire, on peut poursuivre le rafraîchissement de la mémoire à partir du dernier secteur rafraîchi.

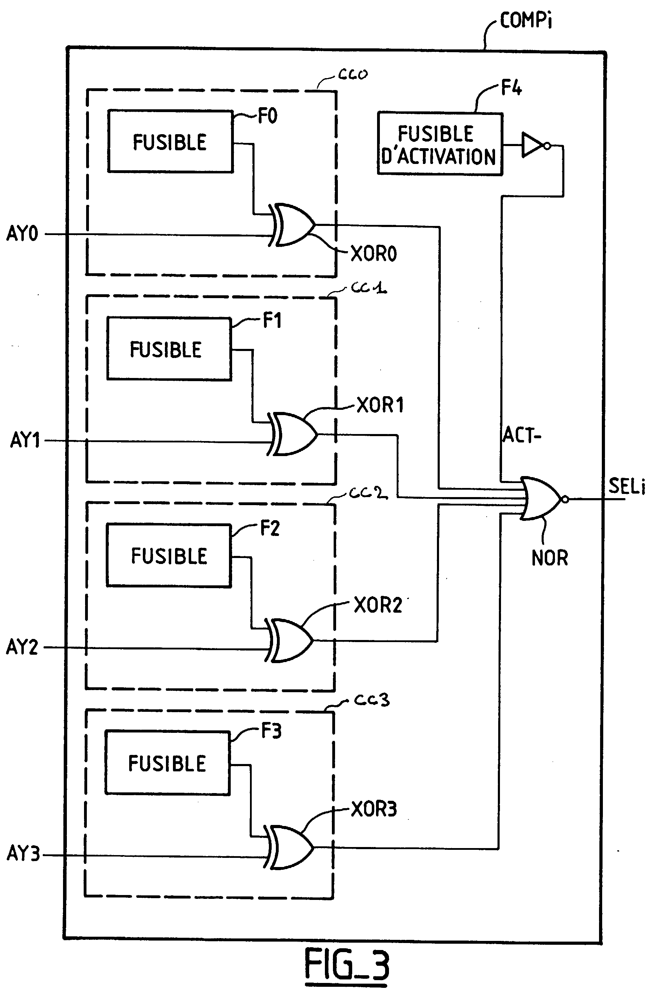

La figure 3 décrit un bloc de comparaison COMPi compris dans les moyens programmables 4B. Chaque bloc de comparaison comporte quatre cellules de comparaison CC0...CC3 permettant de comparer chacune un bit de l'adresse secteur AY0-AY3 avec un bit préenregistré dans le bloc. Par exemple, la cellule de comparaison CC0 compare le bit d'adresse AY0 avec un bit d'adresse mémorisé dans un fusible F0. Si les deux bits d'adresse sont identiques, la cellule de comparaison délivre en sortie un "0" sinon elle délivre un "1". Il en est de même pour les cellules CC1, CC2 et CC3.

La cellule de comparaison CC0 est constituée d'une porte logique XOR0 de type OU exclusif recevant en entrée le bit d'adresse AY0 et le bit d'adresse fourni par le fusible F0. Les cellules de comparaison CC1, CC2 et CC3 sont identiques à la cellule CC0. Les sorties de ces cellules sont connectées aux entrées d'une porte logique NOR de type NON OU. La porte logique NOR reçoit par ailleurs sur une cinquième entrée un signal d'activation ACT-. Ce signal est le signal inverse d'un signal délivré par un fusible F4. Le fusible F4 mémorise le bit d'activation du bloc de comparaison. La porte NOR du bloc de comparaison COMPi délivre en sortie le signal de sélection SELi. Le signal SELi est égal à "1" si toutes ses entrées sont à "0", en particulier le bit d'activation est obligatoirement égal à "1" pour que la porte NOR délivre un "1".

Par ce moyen de comparaison, si l'adresse AY0-AY3 est égale à l'adresse préenregistrée dans le bloc de comparaison COMPi et si le bit d'activation contenu dans ce bloc est égal à "1", alors le signal de sélection SELi présente un niveau haut et sélectionne la ou les lignes de bit qui lui sont associées.

Les fusibles des blocs de comparaison sont de préférence des cellules mémoire de type FLASH EPROM ou E²PROM. Des moyens internes à la mémoire sont prévus pour la programmation de ces fusibles ainsi que pour la duplication des données dans le secteur de rafraîchissement.

Par ailleurs, si l'utilisateur désire écrire une donnée dans un secteur en cours de rafraîchissement, l'opération de duplication est momentanément stoppée, la donnée est écrite dans le secteur qui était en cours de duplication puis l'opération de duplication est poursuivie. En fin de duplication, une opération de vérification compare le contenu du secteur dupliqué à celui du secteur de rafraîchissement.

Ainsi, si la donnée écrite concernait une partie du secteur qui n'avait pas encore été dupliquée au moment de l'écriture, cette donnée a donc été ensuite dupliquée dans le secteur de rafraîchissement et l'opération de vérification ne détecte donc aucune anomalie. Si cette donnée concernait une partie du secteur déjà dupliquée, l'opération de vérification décèle une anomalie entre les deux secteurs et l'opération de duplication est alors réitérée. Dans une version plus élaborée, on pourra prévoir de ne réécrire dans le secteur de rafraîchissement que la nouvelle donnée .

Bien entendu, le rafraîchissement de la mémoire décrit dans cette demande pourra être adapté pour des mémoires autres que des mémoires multiniveau.

## Revendications

1. Mémoire non volatile modifiable électriquement comportant une matrice (1) de cellules mémoire chacune susceptible de mémoriser au moins deux bits d'information, laquelle matrice (1) est divisée en n secteurs de stockage de données, des moyens d'adressage (3,4) et de programmation (7) de ladite matrice, l'ensemble étant commandé par un circuit de commande (2) comprenant des moyens de rafraîchissement (2A), ladite mémoire étant caractérisée en ce que, dans la matrice, n-1 secteurs seulement sont affectés simultanément au stockage des données, le secteur restant ou secteur de rafraîchissement étant alors disponible à des fins de rafraîchissement pour la duplication de l'un desdits n-1 secteurs affectés simultanément au stockage des données, et en ce que, après chaque duplication, le secteur dupliqué est remplacé par ledit secteur de rafraîchissement et devient lui-même le nouveau secteur de rafraîchissement, de telle sorte que l'ensemble des n secteurs participent tour à tour au rafraîchissement.

2. Mémoire selon la revendication 1 caractérisée en ce que, pour le rafraîchissement d'un secteur parmi les n-1 secteurs affectés simultanément au stockage des données, on effectue les étapes suivantes :
(a) duplication des données du secteur à rafraîchir dans le secteur de rafraîchissement;
(b) modification des adresses des données du secteur dupliqué pour qu'elles pointent sur les données du secteur de rafraîchissement;
(c) effacement du secteur dupliqué qui devient le nouveau secteur de rafraîchissement;

3. Mémoire selon la revendication 2, caractérisée en ce que, pour réaliser l'étape (b), les moyens d'adressage (3,4) de ladite matrice comportent des moyens programmables (4B) pour réorganiser après duplication le pointage desdites adresses qui correspondaient au secteur dupliqué vers le nouveau secteur qui a remplacé ce dernier.

4. Mémoire selon la revendication 3 caractérisée en ce que les moyens programmables (4B) comportent n blocs de comparaison (COMPi), chaque bloc de comparaison (COMPi) étant associé à un secteur de la matrice, pour comparer des adresses (AX0-AX3) de données contenues dans la mémoire à des adresses de secteur préenregistrées dans chaque bloc de comparaison.

5. Mémoire selon l'une des revendications 1 à 4, caractérisée en ce que le secteur de rafraîchissement et le secteur à dupliquer sont physiquement contigus de façon à obtenir un rafraîchissement tournant des secteurs de la mémoire.

## Patentansprüche

1. Elektrisch modifizierbarer, nicht-flüchtiger Speicher mit einer Matrix (1) aus Speicherzellen, die jeweils zum Abspeichern von Information mit wenigstens zwei Bits geeignet sind, wobei jede Zelle (1) in n Sektoren zum Speichern von Daten unterteilt ist, und mit Adressierungs- (3, 4) und Programmierungsvorrichtungen (7) für die Matrix, wobei die Einheit durch einen Steuerschaltkreis (2) mit Auffrischungsvorrichtungen (2A) gesteuert wird,
wobei der Speicher dadurch gekennzeichnet ist, daß
in der Matrix nur n - 1 Sektoren gleichzeitig bei der Speicherung von Daten betroffen sind,
der verbleibende Sektor oder Auffrischungssektor daher bis zum Ende der Auffrischung für die Duplizierung des einen der n - 1 bei der Speicherung der Daten betroffenen Sektoren verfügbar bleibt,
und daß nach jeder Duplizierung der duplizierte Sektor durch den Auffrischungssektor ersetzt wird und selbst zum neuen Auffrischungssektor wird, so daß die Einheit aus n Sektoren nach und nach an der Auffrischung teilnimmt.

2. Speicher nach Anspruch 1, dadurch gekennzeichnet, daß zum Auffrischen eines Sektors unter den n - 1 gleichzeitig von der Speicherung von Daten betroffenen Sektoren die folgenden Schritte durchgeführt werden:
(a) Duplizieren von Daten des aufzufrischenden Sektors in dem Auffrischungssektor,
(b) Modifizieren von Adressen von Daten des duplizierten Sektors, so daß diese auf die Daten des Auffrischungssektors zeigen,
(c) Löschen des duplizierten Sektors, der zum neuen Auffrischungssektor wird.

3. Speicher nach Anspruch 2, dadurch gekennzeichnet, daß zum Durchführen von Schritt (b) die Adressierungsvorrichtungen (3, 4) der Matrix programmierbare Vorrichtungen (4B) aufweisen, um nach der Duplizierung die Adressen, die auf den duplizierten Sektor zeigten, so zu aktualisieren, daß sie auf den neuen Sektor zeigen, der den letzteren ersetzt hat.

4. Speicher nach Anspruch 3, dadurch gekennzeichnet, daß die programmierbaren Vorrichtungen (4B) n Vergleichsblöcke (COMPi) umfassen, wobei jeder Vergleichsblock (COMPi) einem Sektor der Matrix zugeordnet ist, um Adressen (AXO - AX3) von Daten in dem Speicher bei vorher abgelegten Sektoradressen in jedem Vergleichsblock zu vergleichen.

5. Speicher nach einem der Ansprüche 1 bis 4, dadurch gekennzeichnet, daß der Auffrischungssektor und der zu duplizierende Sektor physikalisch aufeinander folgen, so daß eine umlaufende Auffrischung der Speichersektoren erreicht wird.

## Claims

1. Electrically modifiable non-volatile memory having a matrix (1) of memory cells each able to store at least two information bits, the said matrix (1) being divided into n data storage sectors, means of addressing (3, 4) and programming (7) the said matrix, the whole being controlled by a control circuit (2) comprising refresh means (2A), the said memory being characterised in that, in the matrix, n-1 sectors only are allocated simultaneously to the storage of the data, the remaining sector or the refresh sector then being available for the purpose of refreshing for duplicating one of the said n-1 sectors allocated simultaneously to the storage of the data, and in that, after each duplication, the duplicated sector is replaced by the said refresh sector as itself becomes the new refresh sector, so that all the n sectors participate in turn in the refreshing.

2. Memory according to Claim 1, characterised in that, for refreshing one sector amongst the n-1 sectors allocated simultaneously to the storage of the data, the following steps are performed:
a) duplicating the data of the sector to be refreshed in the refresh sector;
b) modifying the addresses of the data of the duplicated sector so that they point to the data of the refresh sector;
c) erasing the duplicated sector, which becomes the new refresh sector.

3. Memory according to Claim 2, characterised in that, in order to perform step (b), the means of addressing (3, 4) the said matrix include programmable means (4B) for reorganising, after duplication, the pointing of the said addresses which corresponded to the duplicated sector to the new sector which replaced the latter.

4. Memory according to Claim 3, characterised in that the programmable means (4B) have n comparison blocks (COMPi), each comparison block (COMPi) being associated with a sector of the matrix, for comparing addresses (AX0-AX3) of data contained in the memory with sector addresses prerecorded in each comparison block.

5. Memory according to one of Claims 1 to 4, characterised in that the refresh sector and the sector to be duplicated are physically contiguous so as to obtain a rotating refreshing of the memory sectors.
